# EUROPEAN PATENT SPECIFICATION

(11) **EP 4 544 291 B1**
(45) Date of publication and mention of the grant of the patent: **28.01.2026**
(21) Application number: 23726068.2
(22) Date of filing: 10.05.2023
(51) Int. Cl.: G01N 21/952, G01B 11/25, G01B 11/245, H02G 1/14, H02G 1/16, H01R 43/00, G01B 11/24

(54) **METHOD OF QUALITY INSPECTION OF A JOINT OF A POWER CABLE**
VERFAHREN ZUR QUALITÄTSPRÜFUNG EINER KABELVERBINDUNG EINES HOCHSPANNUNGSKABELS
PROCÉDÉ DE CONTROLE DE QUALITÉ D'UN JOINT DE CABLE ELECTRIQUE HAUTE TENSION

(30) Priority: 22.06.2022 EP 22180574
(43) Date of publication of application: 30.04.2025
(73) Proprietor: NKT HV Cables AB, 371 60 Lyckeby (SE)
(72) Inventor: GUSTAFSSON, Kristian, 371 41 Karlskrona (SE); ABBASI, Amirhossein, 371 52 Karlskrona (SE)
(74) Representative: Kransell & Wennborg KB
(86) International application number: PCT/EP2023/062485
(87) International publication number: WO 2023/247106

(56) References cited:
- EP-A1- 3 547 474
- EP-A1- 3 901 571
- WO-A1-2017/068398
- HE HAOHUI ET AL: "Measurement of 3D shape of cable sealing layer based on structured light binocular vision", PROCEEDINGS OF THE SPIE, SPIE, US, vol. 11781, 28 February 2021 (2021-02-28), pages 117811L - 117811L, XP060139181, ISSN: 0277-786X, ISBN: 978-1-5106-5738-0, DOI: 10.1117/12.2591369

## Description

### TECHNICAL FIELD

The present disclosure generally relates to power cables.

### BACKGROUND

High voltage (HV) power cables generally include, from inside to outside: a conductor, an insulation system, and an outer sheath. In particular, the insulation system comprises an inner semiconducting layer, an insulating layer arranged around the inner semiconducting layer, and an outer semiconducting layer arranged around the insulating layer.

It is required to mechanically process an HV power cable when for example making a joint. The processing includes peeling off the outer semiconducting layer and may include subsequent grinding of the insulating layer, depending on the voltage rating of the cable.

It is important that the processed layers have an even surface structure. A conventional method of inspecting the processing result is a manual inspection of the processed layers relying on tactile feedback, by sliding a finger over the processed area. The quality of a manual inspection depends on the experience of the inspecting person.

Other conventional methods include measurement with a slide gauge or with a diameter tape. In general, conventional methods of inspecting the insulation of an HV cable after processing have limitations as to their reliability and replicability.

EP 3 901 571 A1 discloses a system and a method for determining the quality of a surface of a high voltage cable end. The method comprises moving a noncontact surface scanner about the cable end, measuring distance to the surface over the area of the surface by sequentially measuring a plurality of sub-areas of the area of the surface, creating a continuous 3D surface geometry measurement of the cable end and comparing, using the continuous 3D surface geometry measurement with at least one surface geometry acceptance threshold determining the quality of the surface of the high voltage cable end.

EP3547474 A1 describes a method and the corresponding apparatus for inspecting cable joints by scanning the joint region using an ultrasonic sensor.

### SUMMARY

An object of the present disclosure is to provide a method of performing quality inspection of a power cable which solves or at least mitigates the problems of the prior art.

There is hence according to a first aspect of the present disclosure provided a method of performing a quality inspection of a vulcanized joint of a power cable during manufacturing of the vulcanized joint, the method comprising: a) obtaining, from a laser scanner, measurements of an outer surface of an inner semiconducting layer provided over a conductor joint which joints conductors of two power cable sections, and of a transition area between the outer surface and outer surfaces of a respective inner semiconducting layer of the two power cable sections, b) obtaining, from a laser scanner, measurements of an outer surface of a tapering section of an insulation layer arranged around a respective one of the inner semiconducting layers of the two cable sections, c) processing the measurements obtained in step a) and in step b), the processing involving generating one or a respective 3-d model of the outer surfaces and evaluating an outer surface quality of the outer surfaces based on the one or more 3-d models, d) presenting a conclusion regarding surface quality based on the evaluation, e) obtaining, from a laser scanner, measurements of an outer surface of a joint insulation arranged around the inner semiconducting layer that is provided over the conductor joint, the joint insulation having been provided over the inner semiconducting layer provided around the conductor joint after step d), and f) processing the measurements obtained from the laser scanner in step e), the processing involving determining an insulation thickness or an outer diameter of the joint insulation, and g1) presenting the insulation thickness or outer diameter, and/or, g2) evaluating the insulation thickness or outer diameter, and presenting a conclusion regarding the insultation thickness or outer diameter based on the comparison.

The quality of all processed layers of a vulcanised joint may thus be determined using an automated process which is not dependent on the experience of the personnel carrying out the jointing. A vulcanised joint of the required quality can thus be built without having to rely heavily on human experience.

The processing in step c) may involve determining an angle or slope of the tapering sections. Step d) may in this case involve presenting the angle or slope of the tapering sections. To have the correct angle/slope of the tapering sections, or cones, is of importance when carrying out the jointing.

According to one embodiment step f) involves generating a 3-d model of the outer surface of the joint insulation.

According to one embodiment the evaluating in step c) involves assessing roundness and surface texture of the outer surfaces.

According to one embodiment the evaluating in step c) involves comparing each 3-d model with a respective reference 3-d model.

According to one embodiment the evaluating in step g2) involves comparing the insulation thickness or the outer diameter with a reference.

According to one embodiment the reference is a 3d model of the joint insulation.

According to one embodiment the laser scanner is a 3d laser scanner.

According to a second aspect of the present disclosure there is provided a quality inspection system comprising: processing circuitry, a laser scanner configured to send measurements to the processing circuitry, and a storage medium comprising computer code which when executed by the processing circuitry causes the quality inspection system to carry out the method of the first aspect.

There is according to a third aspect of the present disclosure provided a method of making a vulcanized joint of a power cable utilising the quality inspection system of the second aspect, the method comprising: A) making a conductor joint between two conductor ends of respective power cable lengths, to form a single power cable with two power cable sections separated by the conductor joint, B) making a respective insulation layer of the two power cable sections tapering, C) providing an inner semiconducting layer around the conductor joint, the inner semiconducting layer contacting respective inner semiconducting layers of the power cable sections, D) making a quality inspection of the outer surface of the inner semiconducting layers and of the tapering outer surfaces of the insulation layers of the two power cable sections using the quality inspection system, wherein if the outcome of the quality inspection is a fail, the method comprises E) mechanically processing the outer surface(s) of the inner semiconducting layer(s) and/or the tapering outer surfaces, and repeating step D), wherein if the outcome of the quality inspection is a pass, the method comprises F) making a joint insulation over the inner semiconducting layer provided around the conductor joint, the joint insulation contacting the tapering outer surfaces, G) making a quality inspection of the joint insulation using the quality inspection system to determine an outer diameter or insulation thickness of the joint insulation, wherein if the outcome of the quality inspection in step G) is a fail, the method comprises H) mechanically processing the outer surface of the joint insulation, and repeating steps G) and H) until the outcome of the quality inspection in step G) is a pass.

Generally, all terms used in the claims are to be interpreted according to their ordinary meaning in the technical field, unless explicitly defined otherwise herein. All references to "a/an/the element, apparatus, component, means", etc. are to be interpreted openly as referring to at least one instance of the element, apparatus, component, means, etc., unless explicitly stated otherwise.

### BRIEF DESCRIPTION OF THE DRAWINGS

The specific embodiments of the inventive concept will now be described, by way of example, with reference to the accompanying drawings, in which:
Fig. 1 is a block diagram of a quality inspection system;
Fig. 2 schematically shows a laser scanner scanning a vulcanized joint, during manufacturing of the vulcanised joint, shown in a longitudinal section;
Fig. 3 schematically shows a laser scanner scanning a vulcanized joint shown in a longitudinal section; and
Fig. 4 is a flowchart of a method of making a vulcanised joint, including performing quality inspection of the vulcanized joint.

### DETAILED DESCRIPTION

The inventive concept will now be described more fully hereinafter with reference to the accompanying drawings, in which exemplifying embodiments are shown. The inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description.

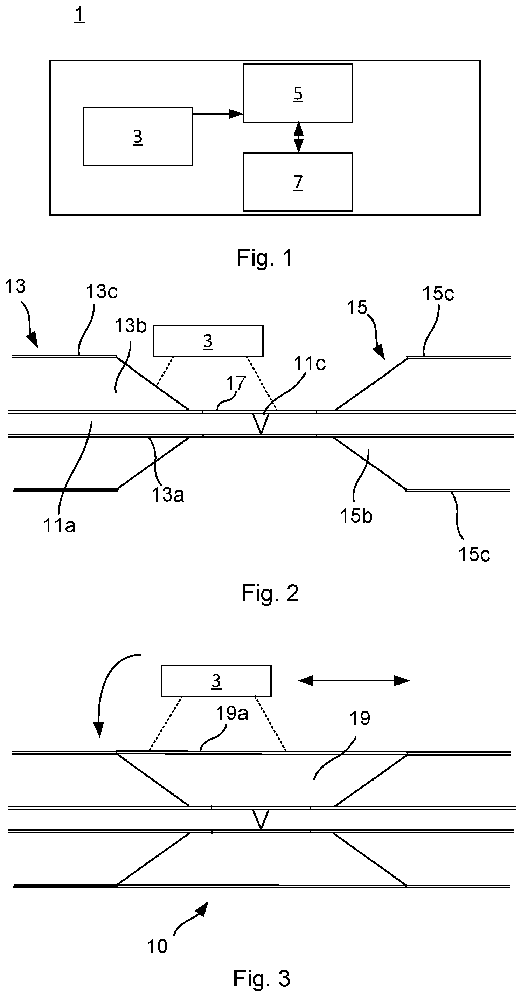

Fig. 1 shows a block diagram of an example of a quality inspection system 1. The quality inspection system 1 is configured to provide a quality inspection of insulation system layers of a vulcanized joint of a power cable, during the manufacturing process of the vulcanised joint.

The power cable may be an underground power cable or a submarine power cable. The power cable may be an AC or a DC power cable. The power cable may be a medium voltage or high voltage power cable.

The quality inspection system 1 comprises a laser scanner 3. The laser scanner may be a 3-d laser scanner. The laser scanner 3 may be handheld.

Thus, a user may hold the laser scanner 3 in their hand(s) when scanning an object such as a vulcanized joint. Alternatively, the laser scanner 3 may be mounted to a structure which enables axial movement along a power cable and/or circumferential movement in a circumferential direction around a power cable.

The quality inspection system 1 comprises processing circuitry 5 connected to the laser scanner 3. Further, the quality inspection system 1 may comprise a storage medium 7 configured to communicate with the processing circuitry 5.

The processing circuitry 5 and/or the storage medium 7 may be integrated with the laser scanner 3, or one or both of the processing circuitry 5 and the storage medium 7 may be arranged separately from the laser scanner 3.

The processing circuitry 5 may for example use any combination of one or more of a suitable central processing unit (CPU), multiprocessor, microcontroller, digital signal processor (DSP), application specific integrated circuit (ASIC), field programmable gate arrays (FPGA) etc., capable of executing any herein disclosed operations concerning quality inspection of a vulcanized joint of a power cable.

The storage medium 7 may for example be embodied as a memory, such as a random access memory (RAM), a read-only memory (ROM), an erasable programmable read-only memory (EPROM), or an electrically erasable programmable read-only memory (EEPROM) and more particularly as a non-volatile storage medium of a device in an external memory such as a USB (Universal Serial Bus) memory or a Flash memory, such as a compact Flash memory.

A method of making a vulcanised joint 10, shown in Fig. 3, will now be described with reference to Figs 2-4. The making of the vulcanised joint 10 typically involves manual labour steps carried out by factory personnel in a cable factory, or by field personnel for example on a cable laying vessel, and quality inspection carried out during the making of the vulcanised joint 10 involves use of the quality inspection system 1, for example operated by factory/field personnel.

Fig. 2 schematically shows the process of making a vulcanized joint using the quality inspection system 1. A vulcanized joint is a flexible joint that usually is made in the factory but can also be made in the field, for example on a cable laying vessel. The vulcanized joint 10 joins two power cable sections, which thus form a single power cable. The power cable sections comprise a respective conductor 11a, 11b, which are joined by means of a conductor joint 11c. Further, each power cable length comprises a respective insulation system 13, 15. Each insulation system 13, 15 comprises an inner semiconducting layer 13a, 15a arranged around the respective conductor 11a, 11b, an insulation layer 13b, 15b arranged around the inner semiconducting layer 13a, 15a, and an outer semiconducting layer 13c, 15c arranged the insulation layer 13b, 15b.

The inner semiconducting layer 13a, 15a may for example comprise crosslinked polyethylene (XLPE). The insulation layer 13b, 15b may comprise XLPE. The outer semiconducting layer 13c, 15c may comprise XLPE.

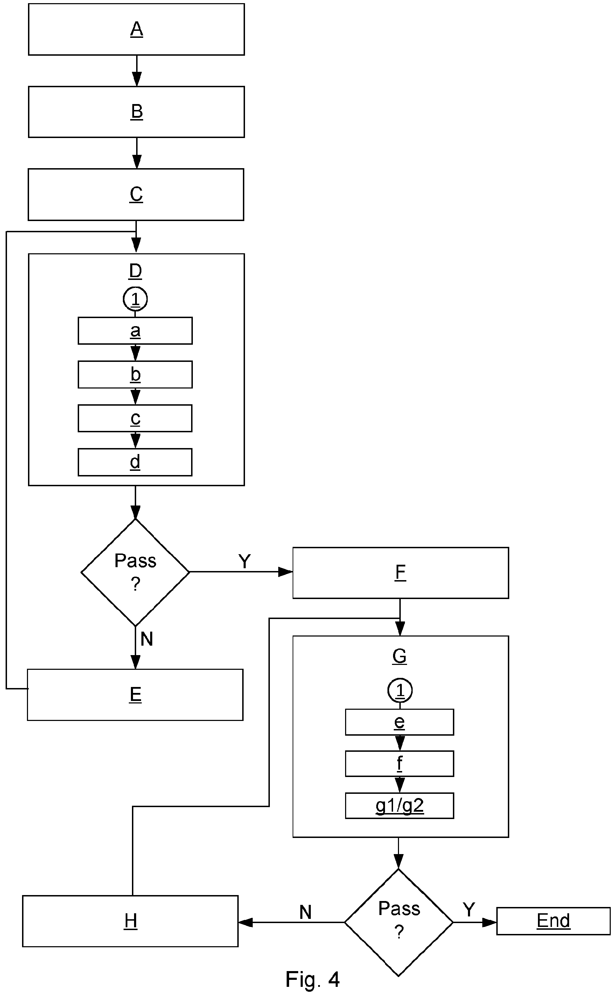

Before jointing, the cable ends of two power cable lengths are processed by removing the insulation system 13, 15 to expose the conductors 11a and 11b. The conductors 11a and 11b are then in a step A), shown in Fig. 4, joined to form the conductor joint 11c, shown in Fig. 2. The jointing may be made by means of welding, for example to make a V-shaped weld.

In a step B) the two facing ends of the respective insulation layer 13b and 15b are made tapering such that they taper towards each other. The facing ends of the insulation layers 13b and 15b are made tapering by mechanical processing.

In a step C) an inner semiconducting layer 17 is arranged over the conductor joint 11c and an entire naked section of the conductors 11a and 11b after their joining. The inner semiconducting layer 17 is arranged to overlap the two inner semiconducting layers 13a and 15a of the two jointed power cable lengths, which now are power cable sections of the jointed power cable. The region of overlap between the inner semiconducting layer 17 and the two inner semiconducting layers 13a and 15a are transition areas of the common inner semiconducting layer of the power cable formed by the two jointed power cable lengths.

The inner semiconducting layer 17 may for example be made by winding layers of tape around the conductor joint 11c and the naked sections of the conductors 11a, and 11b, and heating the layers of tape to crosslink the inner semiconducting layer 17, or the inner semiconducting layer 17 may be done by injection moulding followed by further heating.

In a step D) a quality inspection of the outer surface of the inner semiconducting layers 17, 13a, 15a is made using the quality inspection system 1. The laser scanner 3, for example held by factory or field personnel, is moved over and scans the outer surface of the inner semiconducting layer 17 and the transition areas.

In a step a) measurements of the outer surface of the inner semiconducting layer 17 and the transition areas is obtained by the processing circuitry 5 during step D).

Further, in step D) the laser scanner 3 is moved over the tapering section of each of the insulation layers 13b and 15b, scanning the outer surface of the tapering sections.

In a step b) the processing circuitry 5 obtains the measurements of the outer surfaces of the tapering sections, from the laser scanner 3.

In a step c) the measurements obtained in step a) and in step b) are processed by the processing circuitry 5.

The processing involving generating a single or a respective 3-d model of the outer surfaces and evaluating an outer surface quality of the outer surfaces based on the one or more 3-d models. Thus, according to one example measurements from each outer surface region may be used to generate a respective 3-d model, each for example modelling a respective transition area, and the outer surface of the inner semiconducting layer 17 between the transition areas, or a single 3-d model may be generated, modelling all the scanned outer surfaces.

The evaluating in step c) may involve comparing each 3-d model with a respective reference 3-d model and determining whether the surface quality passes or fails predefined criteria. The evaluating in step c) may for example involve assessing the roundness of the outer surfaces, measured e.g., along their perimeter, and/or assessing a surface texture, such as smoothness and irregularities, of the outer surfaces. Roundness and surface texture may for example be evaluated by comparing determined parameters with respective acceptable thresholds or a degree of deviation from the reference 3-d model(s).

In a step d) a conclusion regarding surface quality based on the evaluation is presented by the quality inspection system 1. The presentation may be visual, for example on a display, and/or aural, e.g., by making a predefined sound if the surface quality passes the predefined criteria or fails the predefined criteria.

If the outcome of the quality inspection of the outer surfaces of steps c)-d) is a fail, the method of making the vulcanised joint comprises a step E) mechanically processing the outer surface(s) of the inner semiconducting layer(s), transition areas, and/or the tapering outer surfaces, and repeating the quality inspection of these outer surfaces after the mechanical processing.

Once the outcome of the quality inspection is a pass, the method of making the vulcanised joint comprises a step of F) making a joint insulation 19 over the inner semiconducting layer 17 provided around the conductor joint 11c. The joint insulation 19 extends between and contacts the tapering outer surfaces. The joint insulation 19 may for example be done by winding layers of an insulation tape around the inner semiconducting layer 17 and subjecting the insulation tape to heat treatment for crosslinking, or it could be made by means of injection moulding followed by heat treatment.

After step F), a step G) of making a quality inspection of the joint insulation 19 is made e.g., by factory personnel or field personnel, using the quality inspection system 1, to determine the outer diameter or insulation thickness of the joint insulation 19.

In a step e) measurements of an outer surface 19a of the joint insulation 19 are obtained from the laser scanner 3, which scans the outer surface 19a of the joint insulation 19 during step G).

In a step f) carried out by the quality inspection system 1, the measurements obtained from the laser scanner 3 in step e) are processed by the processing circuitry 5. The processing involves determining an insulation thickness or an outer diameter of the joint insulation 19.

Further, in a step g1) carried out by the quality inspection system 1, the insulation thickness or outer diameter of the joint insulation 19 is presented. The presenting may be on a display of the quality inspection system 1 and/or it may be aural. In a step g2), which may be carried out in addition to step g1) or as an alternative to step g1) by the quality inspection system 1, the insulation thickness or outer diameter is evaluated, and a conclusion regarding the insultation thickness or outer diameter based on the comparison is presented. The presenting may be on a display of the quality inspection system 1 and/or it may be aural.

The evaluating in step g2) may involve comparing the insulation thickness or the outer diameter with a reference. The reference may be a 3d model of the joint insulation 19.

If the outcome of the quality inspection in step G) is a fail, the method comprises H) mechanically processing the outer surface 19a of the joint insulation 19, and repeating steps G) and H) until the outcome of the quality inspection in step G) is a pass.

The inventive concept has mainly been described above with reference to a few examples. However, as is readily appreciated by a person skilled in the art, other embodiments than the ones disclosed above are equally possible within the scope of the inventive concept, as defined by the appended claims.

## Claims

1. Method of performing a quality inspection of a vulcanized joint (10) of a power cable during manufacturing of the vulcanized joint (10), the method comprising:
a) obtaining, from a laser scanner (3), measurements of an outer surface of an inner semiconducting layer (17) provided over a conductor joint (11c) which joints conductors (11a, 11b) of two power cable sections, and of a transition area between the outer surface and outer surfaces of a respective inner semiconducting layer (13a, 15a) of the two power cable sections,
b) obtaining, from a laser scanner (3), measurements of an outer surface of a tapering section of an insulation layer (13b, 15b) arranged around a respective one of the inner semiconducting layers (13a, 15a) of the two cable sections,
c) processing the measurements obtained in step a) and in step b), the processing involving generating one or a respective 3-d model of the outer surfaces and evaluating an outer surface quality of the outer surfaces based on the one or more 3-d models,
d) presenting a conclusion regarding surface quality based on the evaluation,
e) obtaining, from a laser scanner (3), measurements of an outer surface of a joint insulation (19) arranged around the inner semiconducting layer (17) that is provided over the conductor joint (11c), the joint insulation (19) having been provided over the inner semiconducting layer (17) provided around the conductor joint (11c) after step d), and
f) processing the measurements obtained from the laser scanner (3) in step e), the processing involving determining an insulation thickness or an outer diameter of the joint insulation (19), and
g1) presenting the insulation thickness or outer diameter, and/or,
g2) evaluating the insulation thickness or outer diameter, and presenting a conclusion regarding the insultation thickness or outer diameter based on the evaluation.

2. Method as claimed in claim 1, wherein step f) involves generating a 3-d model of the outer surface of the joint insulation.

3. Method as claimed in claim 1 or 2, wherein the evaluating in step c) involves assessing roundness and surface texture of the outer surfaces.

4. Method as claimed in any of the preceding claims, wherein the evaluating in step c) involves comparing each 3-d model with a respective reference 3-d model.

5. Method as claimed in any of the preceding claims, wherein the evaluating in step g2) involves comparing the insulation thickness or the outer diameter with a reference.

6. Method as claimed in claim 5, wherein the reference is a 3d model of the joint insulation.

7. Method as claimed in any of the preceding claims, wherein the laser scanner (3) is a 3d laser scanner (3).

8. A quality inspection system (1) comprising:
processing circuitry (5),
a laser scanner (3) configured to send measurements to the processing circuitry (5), and
a storage medium (7) comprising computer code which when executed by the processing circuitry (5) causes the quality inspection system (1) to carry out the method as claimed in any of the preceding claims.

9. Method of making a vulcanized joint (10) of a power cable utilising the quality inspection system (1) of claim 8, the method comprising:
A) making a conductor joint (11c) between two conductor ends of respective power cable lengths, to form a single power cable with two power cable sections separated by the conductor joint (11c),
B) making a respective insulation layer (13b, 15b) of the two power cable sections tapering,
C) providing an inner semiconducting layer (17) around the conductor joint (11c), the inner semiconducting layer (17) contacting respective inner semiconducting layers (13a, 15a) of the power cable sections,
D) making a quality inspection of the outer surface of the inner semiconducting layers (17) and of the tapering outer surfaces of the insulation layers (13b, 15b) of the two power cable sections using the quality inspection system (1),
wherein if the outcome of the quality inspection is a fail, the method comprises E) mechanically processing the outer surface(s) of the inner semiconducting layer(s) and/or the tapering outer surfaces, and repeating step D),
wherein if the outcome of the quality inspection is a pass, the method comprises F) making a joint insulation (19) over the inner semiconducting layer (17) provided around the conductor joint (11c), the joint insulation (19) contacting the tapering outer surfaces,
G) making a quality inspection of the joint insulation (19) using the quality inspection system (1) to determine an outer diameter or insulation thickness of the joint insulation (19),
wherein if the outcome of the quality inspection in step G) is a fail, the method comprises H) mechanically processing the outer surface of the joint insulation (19), and repeating steps G) and H) until the outcome of the quality inspection in step G) is a pass.

## Patentansprüche

1. Verfahren zum Durchführen einer Qualitätsprüfung einer vulkanisierten Kabelverbindung (10) eines Hochspannungskabels während des Herstellens der vulkanisierten Kabelverbindung (10), wobei das Verfahren Folgendes umfasst:
a) Erhalten, von einem Laserscanner (3), von Messungen einer Außenfläche einer inneren Halbleiterschicht (17), die über einer Leiterkabelverbindung (11c) bereitgestellt ist, die Leiter (11a, 11b) von zwei Hochspannungskabelabschnitten verbindet, und von einem Übergangsbereich zwischen der Außenfläche und Außenflächen einer jeweiligen inneren Halbleiterschicht (13a, 15a) der zwei Hochspannungskabelabschnitte,
b) Erhalten, von einem Laserscanner (3), von Messungen einer Außenfläche eines sich verjüngenden Abschnitts einer Isolationsschicht (13b, 15b), die um eine entsprechende eine der inneren Halbleiterschichten (13a, 15a) der zwei Kabelabschnitte angeordnet ist,
c) Verarbeiten der Messungen, die in Schritt a) und in Schritt b) erhalten werden, wobei das Verarbeiten das Erzeugen eines oder mehrerer entsprechender 3D-Modelle der Außenflächen und das Bewerten einer Außenflächenqualität der Außenflächen anhand des einen oder mehrerer 3D-Modelle einschließt,
d) Präsentieren einer Schlussfolgerung bezüglich der Oberflächenqualität anhand der Bewertung,
e) Erhalten, von einem Laserscanner (3), von Messungen einer Außenfläche einer Kabelverbindungsisolierung (19), die um die innere Halbleiterschicht (17) angeordnet ist, die über der Leiterkabelverbindung (11c) bereitgestellt ist, wobei die Kabelverbindungsisolierung (19) über der inneren Halbleiterschicht (17), die um die Leiterkabelverbindung (11c) bereitgestellt ist, nach Schritt d) bereitgestellt wurde, und
f) Verarbeiten der Messungen, die von dem Laserscanner (3) in Schritt e) erhalten wurden, wobei das Verarbeiten das Bestimmen einer Isolationsstärke oder eines Außendurchmessers der Kabelverbindungsisolierung (19) einschließt, und
g1) Präsentieren der Isolationsstärke oder des Außendurchmesser, und/oder,
g2) Bewerten der Isolationsstärke oder des Außendurchmessers und Präsentieren einer Schlussfolgerung bezüglich der Isolationsstärke oder des Außendurchmessers anhand der Bewertung.

2. Verfahren nach Anspruch 1, wobei Schritt f) das Erzeugen eines 3D-Modells der Außenfläche der Kabelverbindungsisolierung einschließt.

3. Verfahren nach Anspruch 1 oder 2, wobei das Bewerten in Schritt c) das Beurteilen der Rundheit und der Oberflächentextur der Außenflächen einschließt.

4. Verfahren nach einem der vorhergehenden Ansprüche, wobei das Bewerten in Schritt c) das Vergleichen jedes 3D-Modells mit einem entsprechenden Referenz-3D-Modell einschließt.

5. Verfahren nach einem der vorhergehenden Ansprüche, wobei das Bewerten in Schritt g2) das Vergleichen der Isolationsstärke oder des Außendurchmessers mit einer Referenz einschließt.

6. Verfahren nach Anspruch 5, wobei die Referenz ein 3D-Modell der Kabelverbindungsisolierung ist.

7. Verfahren nach einem der vorhergehenden Ansprüche, wobei der Laserscanner (3) ein 3D-Laserscanner (3) ist.

8. Qualitätsprüfungssystem (1), umfassend:
Verarbeitungsschaltung (5),
einen Laserscanner (3), der so konfiguriert ist, dass er Messungen an die Verarbeitungsschaltung (5) sendet, und
ein Speichermedium (7), umfassend einen Computercode, der, wenn er von der Verarbeitungsschaltung (5) ausgeführt wird, das Qualitätsprüfungssystem (1) veranlasst, das Verfahren nach einem der vorhergehenden Ansprüche auszuführen.

9. Verfahren zum Veranlassen einer vulkanisierten Kabelverbindung (10) eines Hochspannungskabel unter Verwendung des Qualitätsprüfungssystems (1) nach Anspruch 8, wobei das Verfahren Folgendes umfasst:
A) Veranlassen einer Leiterkabelverbindung (11c) zwischen zwei Leiterenden von entsprechenden Hochspannungskabellängen, um ein einzelnes Hochspannungskabel mit zwei Hochspannungskabelabschnitten auszubilden, die durch die Leiterkabelverbindung (11c) getrennt sind,
B) Veranlassen der entsprechenden Isolationsschicht (13b, 15b) der zwei sich verjüngenden Hochspannungskabelabschnitte,
C) Bereitstellen einer inneren Halbleiterschicht (17) um die Leiterkabelverbindung (11c), wobei die innere Halbleiterschicht (17) die entsprechenden inneren Halbleiterschichten (13a, 15a) der Hochspannungskabelabschnitte kontaktiert,
D) Veranlassen einer Qualitätsprüfung der Außenfläche der inneren Halbleiterschichten (17) und der sich verjüngenden Außenflächen der Isolationsschichten (13b, 15b) der zwei Hochspannungskabelabschnitte unter Verwendung des Qualitätsprüfungssystems (1),
wobei, wenn das Ergebnis der Qualitätsprüfung negativ ist, das Verfahren Folgendes umfasst: E) mechanisches Verarbeiten der Außenfläche(n) der inneren Halbleiterschicht(en) und/oder der sich verjüngenden Außenflächen und Wiederholen von Schritt D),
wobei, wenn das Ergebnis der Qualitätsprüfung positiv ist, das Verfahren Folgendes umfasst: F) Veranlassen einer Kabelverbindungsisolierung (19) über der inneren Halbleiterschicht (17), die um die Leiterkabelverbindung (11c) bereitgestellt ist, wobei die Kabelverbindungsisolierung (19) die sich verjüngenden Außenflächen kontaktiert,
G) Veranlassen einer Qualitätsprüfung der Kabelverbindungsisolierung (19) unter Verwendung des Qualitätsprüfungssystems (1), um einen Außendurchmesser oder eine Isolationsstärke der Kabelverbindungsisolierung (19) zu bestimmen,
wobei, wenn das Ergebnis der Qualitätsprüfung in Schritt G) negativ ist, das Verfahren H) das mechanische Verarbeitung der Außenfläche der Kabelverbindungsisolierung (19) und das Wiederholen der Schritte G) und H) umfasst, bis das Ergebnis der Qualitätsprüfung in Schritt G) positiv ist.

## Revendications

1. Procédé de réalisation d'une inspection de qualité d'un raccord vulcanisé (10) d'un câble électrique au cours de la fabrication du raccord vulcanisé (10), le procédé comprenant :
a) l'obtention, à partir d'un scanner laser (3), de mesures d'une surface extérieure d'une couche semi-conductrice intérieure (17) fournie sur un raccord de conducteurs (11c) qui raccorde des conducteurs (11a, 11b) de deux sections de câble électrique, et d'une zone de transition entre la surface extérieure et des surfaces extérieures d'une couche semi-conductrice intérieure (13a, 15a) respective des deux sections de câble électrique,
b) l'obtention, à partir d'un scanner laser (3), de mesures d'une surface extérieure d'une section s'effilant d'une couche d'isolation (13b, 15b) agencée autour de l'une respective des couches semi-conductrices intérieures (13a, 15a) des deux sections de câble,
c) le traitement des mesures obtenues à l'étape a) et à l'étape b), le traitement impliquant la génération d'un modèle 3D ou d'un modèle 3D respectif des surfaces extérieures et l'évaluation d'une qualité de surface extérieure des surfaces extérieures sur la base du ou des modèle 3D,
d) la présentation d'une conclusion en ce qui concerne une qualité de surface sur la base de l'évaluation,
e) l'obtention, à partir d'un scanner laser (3), de mesures d'une surface extérieure d'une isolation de raccord (19) agencée autour de la couche semi-conductrice intérieure (17) qui est fournie sur le raccord de conducteurs (11c), l'isolation de raccord (19) ayant été fournie sur la couche semi-conductrice intérieure (17) fournie autour du raccord de conducteurs (11c) après l'étape d), et
f) le traitement des mesures obtenues à partir du scanner laser (3) à l'étape e), le traitement impliquant la détermination d'une épaisseur d'isolation ou d'un diamètre extérieur de l'isolation de raccord (19), et
g1) la présentation de l'épaisseur d'isolation ou du diamètre extérieur, et/ou
g2) l'évaluation de l'épaisseur d'isolation ou du diamètre extérieur, et la présentation d'une conclusion ce qui concerne l'épaisseur d'isolation ou le diamètre extérieur sur la base de l'évaluation.

2. Procédé selon la revendication 1, dans lequel l'étape f) implique la génération d'un modèle 3D de la surface extérieure de l'isolation de raccord.

3. Procédé selon la revendication 1 ou 2, dans lequel l'évaluation à l'étape c) implique l'examen d'une rondeur et d'une texture de surface des surfaces extérieures.

4. Procédé selon l'une quelconque des revendications précédentes, dans lequel l'évaluation à l'étape c) implique la comparaison de chaque modèle 3D à un modèle 3D de référence respectif.

5. Procédé selon l'une quelconque des revendications précédentes, dans lequel l'évaluation à l'étape g2) implique la comparaison de l'épaisseur d'isolation ou du diamètre extérieur à une référence.

6. Procédé selon la revendication 5, dans lequel la référence est un modèle 3D de l'isolation de raccord.

7. Procédé selon l'une quelconque des revendications précédentes, dans lequel le scanner laser (3) est un laser scanner 3D (3).

8. Procédé d'inspection de qualité (1) comprenant :
une circuiterie de traitement (5),
un scanner laser (3) configuré pour envoyer des mesures à la circuiterie de traitement (5), et
un support de stockage (7) comprenant un code informatique qui, lorsqu'il est exécuté par la circuiterie de traitement (5), amène le système d'inspection de qualité (1) à effectuer le procédé selon l'une quelconque des revendications précédentes.

9. Procédé de réalisation d'un raccord vulcanisé (10) d'un câble électrique à l'aide du système d'inspection de qualité (1) selon la revendication 8, le procédé comprenant :
A) la réalisation d'un raccord de conducteurs (11c) entre deux extrémités de conducteur de longueur respectives de câble électrique, pour former un câble électrique unique avec deux sections de câble électrique séparées par le raccord de conducteurs (11c),
B) la réalisation d'une couche d'isolation (13b, 15b) respective des deux sections de câble électrique s'effilant,
C) la fourniture d'une couche semi-conductrice intérieure (17) autour du raccord de conducteurs (11c), la couche semi-conductrice intérieure (17) étant en contact avec des couches semi-conductrices intérieures (13a, 15a) respectives des sections de câble électrique,
D) la réalisation d'une inspection de qualité de la surface extérieure des couches semi-conductrices intérieures (17) et des surfaces extérieures s'effilant des couches d'isolation (13b, 15b) des deux sections de câble électrique à l'aide du système d'inspection de qualité (1),
dans lequel, si le résultat de l'inspection de qualité est un échec, le procédé comprend E) le traitement mécanique de la ou des surfaces extérieures de la ou des couches semi-conductrices intérieures et/ou des surfaces extérieures s'effilant, et la répétition de l'étape D),
dans lequel, si le résultat de l'inspection de qualité est une réussite, le procédé comprend F) la réalisation d'une isolation de raccord (19) sur la couche semi-conductrice intérieure (17) fournie autour du raccord de conducteurs (11c), l'isolation de raccord (19) étant en contact avec les surfaces extérieures s'effilant,
G) la réalisation d'une inspection de qualité de l'isolation de raccord (19) à l'aide du système d'inspection de qualité (1) pour déterminer un diamètre extérieur ou une épaisseur d'isolation de l'isolation de raccord (19),
dans lequel, si le résultat de l'inspection de qualité à l'étape G) est un échec, le procédé comprend H) le traitement mécanique de la surface extérieure de l'isolation de raccord (19), et la répétition des étapes G) et H) jusqu'à ce que le résultat de l'inspection de qualité à l'étape G) soit une réussite.
